# EUROPEAN PATENT APPLICATION

(11) **EP 4 694 631 A1**
(43) Date of publication of application: **11.02.2026**
(21) Application number: 24193926.3
(22) Date of filing: 09.08.2024
(51) Int. Cl.: H10H 20/85, H10H 20/851

(54) **FLIP-CHIP PACKAGING STRUCTURE OF LIGHT-EMITTING DEVICES**

(71) Applicant: Crocus Labs GmbH, 14469 Potsdam (DE)
(72) Inventor: KIM, Chi Sun, 15732 Schulzendorf (DE); MAKARAM, Prashanth, 13355 Berlin (DE)
(74) Representative: Schulz Junghans Patentanwälte PartGmbB

(57) **Abstract**

The invention relates to a flip-chip packaging structure of a light-emitting device (LEDs) comprising:
a wiring substrate;
a flip-chip semiconductor LED chip electrically connected to the wiring substrate;
a cavity structure on top of the flip-chip semiconductor LED chip;
a color conversion semiconductor quantum dot material embedded inside the cavity structure;
a protective layer on top of the flip-chip semiconductor LED chip and the cavity structure; and
a color conversion phosphor layer entirely or partially encapsulating the LED chip.

## Description

### FIELD OF THE INVENTION

The present invention relates to a packaging light-emitting device (LED), and more specifically, to a flip-chip on board packaging LED that improves color rendering as well as the lifetime and reliability of a white LED by embedding semiconductor quantum dots in a cavity structure on top of a flip-chip type semiconductor LED chip.

### BACKGROUND OF THE INVENTION

Morden LED lamps are widely used for interior lighting, street lighting, automobile interior and headlights, and various decorations. Many white LED lamps used in these applications are typically fabricated by combining blue LED chips with a coating of yellow phosphors that converts the blue light into broad yellow light. Recently, semiconductor quantum dots have been actively researched as photoluminescent materials.

In general, semiconductor quantum dot (QD) materials are semiconductor nanocrystals whose particle size ranges from about 1 nm to several tens of nm and can be excited by external high-energy light and then emit low-energy light dependent on their band gaps like other bulk semiconductors. However, the emission wavelengths from QD materials can be controlled by changing the size of the particles. Therefore, uniformly sized QD materials can be used as photoluminescent materials with high color purity. In addition, semiconductor QD materials are inorganic materials that are more stable and longer in lifespan than organic materials used in organic light emitting diode (OLED) displays.

Semiconductor QDs instead of phosphors for color conversion offer a promising solution to the challenges of achieving a higher color rendering index or CRI for white LEDs. These semiconductor nano crystals, for their extraordinary merits including tunable spectrum, high color saturation, high conversion efficiency, and simple solution processability, are highly efficient light emitters and can be engineered to lack toxic heavy metals. The color of the light produced by QDs depends on their size, which can be manipulated to produce a continuous spectrum, addressing the issue of spectral continuity. In addition, the precise control over the emitted light's color from QDs could lead to a more universally acceptable high CRI, considering the subjectivity of color perception. Thus, QDs present a less complicated and more efficient approach to achieving high CRI in white LEDs.

Although semiconductor QD materials have many advantages when used as photoluminescent materials in light-emitting devices, there are still problems that need to be overcome.

First, when semiconductor QD materials are exposed to high-energy light in an oxygen or moisture ambience, the surface of the QD nanoparticles can be easily oxidized to form oxides, which reduces the conversion efficiency of the QD material. It is called a photo-oxidation reaction. In particular, high-energy light absorbed due to the large surface area of the semiconductor QDs generates a large number of free electrons, which in turn creates oxygen plasma or oxygen ions, which can oxidize or degrade the surface of the semiconductor QD.

Second, Semiconductor QD materials have the problem of very low thermal stability. The heat generated by LED chips can reduce the operational lifetime and reliability of QDs. The operation temperature of white LEDs working under extreme conditions, such as high power or small chip size, will exceed 100 °C, resulting in irreversible damage to the QDs and the devices.

### SUMMARY OF THE INVENTION

It is an object of the invention to provide a flip-chip on board packaging structure of a color-conversion light emitting device (LED) wherein the LED has higher color rendering index using semiconductor quantum dot (QD) materials as well as the phosphor material as the color-conversion materials.

One object of the present invention is to provide a flip-chip on board packaging structure of a color-conversion LED using a flip-chip type semiconductor chip wherein semiconductor QD materials are embedded in cavities on top of the flip-chip type semiconductor LED chip to protect the semiconductor QD material from external moisture or oxygen from the outside.

Another object of the present invention is to provide a flip-chip on board packaging structure of a color-conversion LED having a polymer or silicone resin protective layer disposed on top of the flip-chip type semiconductor LED chip to additionally protect the QD materials inside the cavity structure from any moisture and/or oxygen from the outside, thereby to effectively reduce the photo-oxidation reaction process of the QD materials.

Still another object of the present invention is to provide a flip-chip on board packaging structure of a color-conversion LED having an additional heat dissipation path through the protective layer on top of the flip-chip type semiconductor LED chip so that enhances stability and reliability of the entire LED lamp.

Another object of the present invention is to provide a flip-chip on board packaging structure of a color-conversion LED having a cavity structure with a photonic crystal design on top of the flip-chip type semiconductor LED chip for better light extraction efficiency by reducing the light loss due to total internal reflection.

To achieve these and other advantages and in accordance with the purpose of the present invention, the present invention provides a flip-chip on board packaging structure of a QD-containing color conversion LED including a wiring substrate; a flip-chip type semiconductor LED chip electrically bonded onto the wiring substrate; one or more semiconductor QD materials embedded in a cavity structure for color conversion, wherein the cavity structure having various cavities, holes and/or grooves forms on top of the semiconductor LED chip; a polymer or silicone resin protective layer covered on the semiconductor QD materials in the cavity structure and the top surface of the semiconductor LED chip; and one or more phosphor layers for additional color conversion.

Micromorphologically, the cavity structure on the top of the semiconductor LED chip may comprise cylinder-type holes, polygonal shape cavities, or their 2-dimensional grooves or any other cavities and may be fabricated by wet etching, plasma dry etching, laser drilling, or any other methods. Dimensionally, each cavity may have sub-micron to tens of micron size in lateral and microns to tens of micron size in depth. It is desirable that the end of each cavity facing the light emitting layer be hemispherical or have a gentle curvature.

Various cavities in the cavity structure may be formed on top of the growth substrate and/or the n-type semiconductor epitaxial layer if the growth substrate is removed from the semiconductor LED chip or in some embodiments, they may reach into the n-type semiconductor epitaxial layer through the entire growth substrate.

Specifically, Semiconductor QD materials may be embedded in the cavity structure by various printing technologies like Inkjet or electro-hydrodynamic printings with very high accuracy, and then a transparent protective layer covers the entire the top of the semiconductor LED chip including the semiconductor QD materials in the cavity structure or optionally, may cover the side surface of the semiconductor LED chip and even adjacent area around the wiring substrate.

Additionally and optionally, a heat dissipation path may be disposed on or inside the protective layer in optional embodiments of the present invention, which can be connected to the wiring substrate where a heat sink is attached so that the heat can be easily transferred to protect the semiconductor QD materials from the heat from the top of the semiconductor LED chip.

In some embodiments according to the present invention, one of more phosphor layers may be disposed on the protective layer and cover the entire semiconductor LED chip including its side area and even adjacent area around the wiring substrate.

A portion of the primary light (e.g. blue light) emitted from the active layer of the semiconductor LED chip incident into the cavities can be converted to longer wavelengths by the semiconductor QD materials in the cavity structure. A portion of a first converted light from one semiconductor QD material may be converted to a much longer wavelength by another semiconductor QD material in the same or different cavities while exiting the semiconductor LED chip. A portion of the primary light and/or a portion of relatively short, converted lights by the semiconductor QD materials escaped from the semiconductor LED chip can be converted by the phosphor materials again into longer wavelengths.

Thereby, the flip-chip on board packaging structure of a QD-containing color conversion LED according to some embodiments of the present invention can provide at least the following technical benefits.

1) According to embodiments of the forgoing summary of the invention, the flip-chip on board packaging of the QD-containing color conversion LED is used without a lead frame and wire bindings, therefore, it has a clear benefit for higher emitting output power.

2) Semiconductor QD materials for color conversion offer a promising solution to the challenges of achieving a higher CRI for white LEDs because of their extraordinary merits including tunable spectrum, high color saturation, high conversion efficiency, and simple solution processability. The conversion wavelength of semiconductor QD materials can be tuned by changing the design of the cavity structure or by changing the distribution design or type of semiconductor QD materials within the cavity structure.

3) The semiconductor QD materials is embedded in the cavity structure surrounded by perfect materials like the growth substrate or the semiconductor epitaxial layer and converted by the transparent protective layer which has low water vapor transmission rate, so that the external water vapor and oxygen cannot readily penetrate the cavity structure. It can effectively avoid or reduce the oxidation reaction of semiconductor QD materials causing the optical quenching.

4) In another embodiment of the present invention, the cavity structure on top of the semiconductor LED chip provides various shapes of emitting surfaces depending on the cavity design and can have sub-micron to few micron-sized periodicity in cavity placement on the light-emitting surface, which can reduce the total internal reflection like a phenomenon in a photonic crystal structure on the LED emitting surface.

5) In an optional embodiment of the present invention, a heat dissipation path may be disposed on or inside the protective layer. Therefore, any improvement in device reliability and lifetime of the entire LED lamp as well as in the luminous efficiency can be expected because any heat reaching to the top side of the semiconductor LED chip can be efficiently dissipated to the wiring board instead of affecting the semiconductor QD materials in the cavity structure.

The foregoing summary and the following detailed description are not meant to restrict the invention to any embodiments but are merely meant to describe some embodiments of the invention.

### BRIEF DESCRIPTION OF THE DRAWINGS

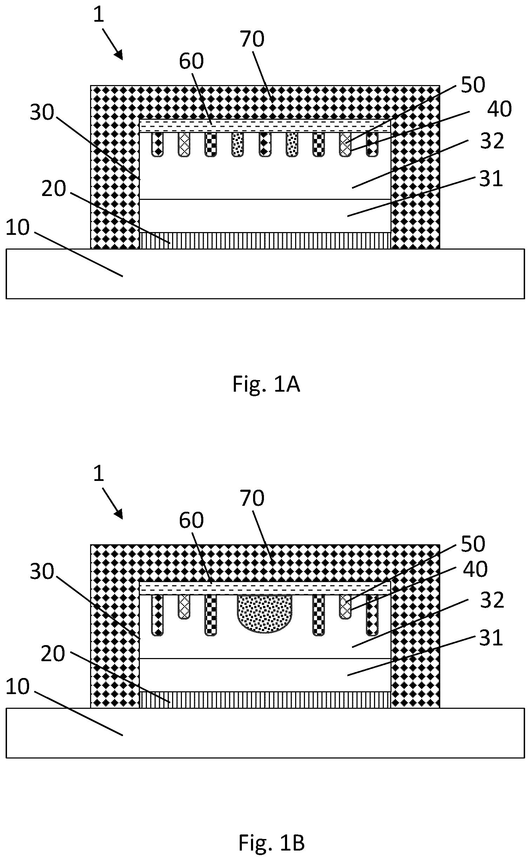

FIG. 1A and Fig. 1B are schematic cross-sectional views showing a flip-chip on board packaging structure of the light-emitting device according to an embodiment of the present invention.

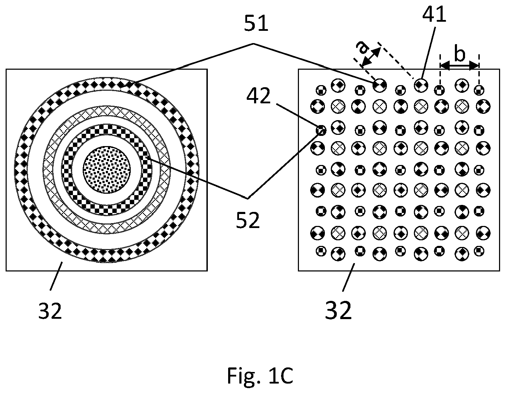

FIG. 1C is a schematic top view of a flip-chip on board packaging structure of the light-emitting device up to the growth substrate wherein the color-conversion semiconductor quantum dot materials are embedded in the cavity structure on top of the growth substrate according to an embodiment of the present invention

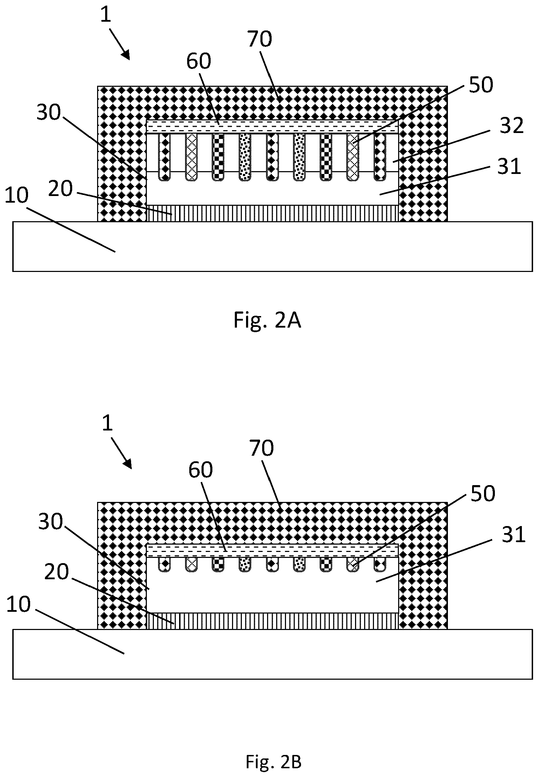

FIG. 2A is a schematic cross-sectional view showing a flip-chip on board packaging structure of the light-emitting device wherein the cavity structure is formed from the top of the growth substrate and reaches into the semiconductor epitaxial layer according to an embodiment of the present invention

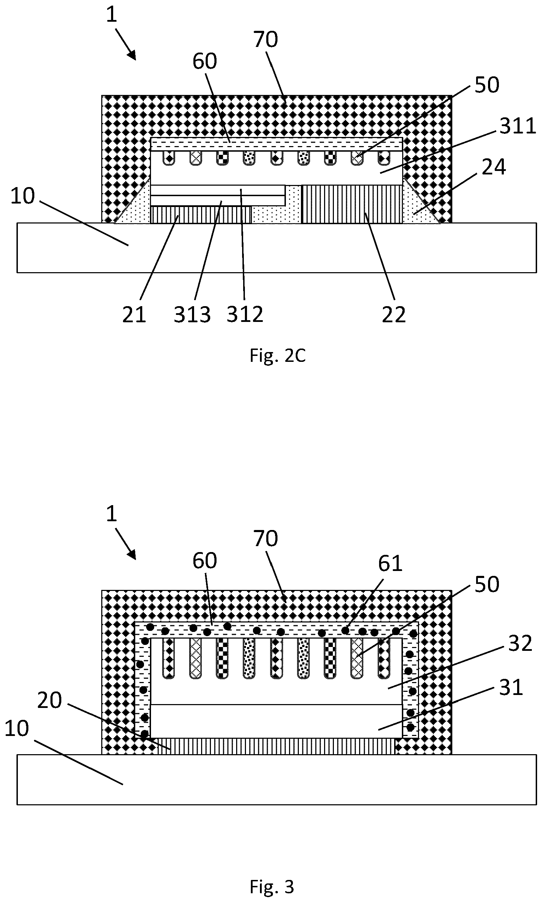

FIG. 2B and FIG. 2C are schematic cross-sectional views showing a flip-chip on board packaging structure of the light-emitting device wherein the cavity structure is formed on top of the semiconductor epitaxial layer without a growth substrate according to an embodiment of the present invention.
FIG. 3 is a schematic cross-sectional view showing a flip-chip on board packaging structure of the light-emitting device wherein the protective layer is disposed on the side surface as well as on the top surface of the semiconductor LED chip and contains anti-reflective particles according to an embodiment of the present invention.

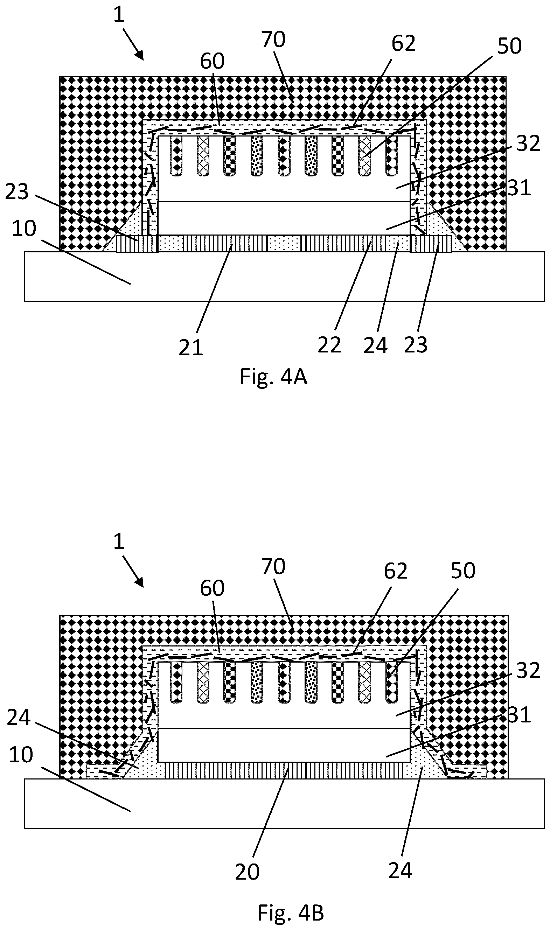

FIG. 4A and FIG. 4B are schematic cross-sectional views showing a flip-chip on board packaging structure of the light-emitting device wherein the protective layer contains thermally conductive nano-lines and is connected to thermal bonding pads or directly on the wiring substrate according to an embodiment of the present invention.

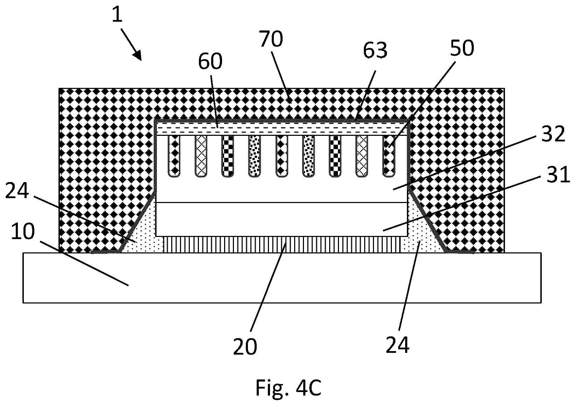

FIG. 4C is a schematic cross-sectional view showing a flip-chip on board packaging structure of the light-emitting device wherein the heat dissipation layer disposed on top of the protective layer and is connected to the wiring substrate directly according to an embodiment of the present invention.

### DETAILED DESCRIPTION OF THE INVENTION

The invention will now be described using exemplary embodiments along with references to accompanying drawings. Exemplary embodiments, may, however, be implemented in more than one form and should not be construed as being limited to the embodiments set forth herein; rather, these exemplary embodiments are provided so that this disclosure is described in a thorough and complete manner and fully conveys the scope of example embodiments of inventive concepts. In the drawings, the thicknesses of layers are non proportional and may not convey actual dimensions; this has been done only for clarity and understanding of the invention.

Like reference characters and/or numerals in the drawings denote like elements, and thus their description may be omitted. It will be understood that when an element is referred to as being "connected' or "coupled to another element, it can be directly connected or coupled to the other element. In contrast, when an element is referred to as being "directly connected" or "directly coupled to another element, there are no intervening elements present.

Other words used to describe the relationship between elements or layers should be interpreted in a like fashion (e.g., "between versus "directly between," "adjacent versus "directly adjacent," "on" versus "directly on"). As used herein the term "and/or" includes any and all combinations of one or more of the associated listed items.

FIGS. 1A and 1B are schematic cross-sectional views of a flip-chip on board packaging structure of the light-emitting device 1 according to an embodiment of the present invention. The light-emitting device (LED) 1 comprises a wiring substrate 10, a flip-chip LED semiconductor chip 30, a bonding layer 20 which electrically connects the LED chip 10 to the wiring substrate, and a cavity structure 40 on top of the flip-chip LED semiconductor chip 30 (hereinafter referred to as LED chip), semiconductor quantum dot (QD) materials 50, a protective layer 60 disposed on top of the LED chip 30 protecting the semiconductor QD materials 50 in the cavity structure 40, and a phosphor layer 70 covering the entire LED chip 30 on top of the protective layer 60.

The LED chip 30 is used to provide a primary light, which may be a short wavelength light such as a blue light and a violet light. The LED chip 30 may have multiple epitaxial layers 31 grown epitaxially on a growth substrate 32 such as Sapphire, SiC, Si, AlN or GaN crystals. Due to the characteristics of the flip-chip structure, the semiconductor epitaxial layer is grown on a first surface (bottom side) of the growth substrate 32 facing the wiring substrate 10. The bonding layer 20 is used to bond and electrically connect the LED chip 30 to the wiring substrate 10, such as a printed circuit board, wherein multiple transparent and/or reflective conductive electrodes (not shown in the figures) may be used to electrically contact the LED chip 30 to the bonding layer 30.

A cavity structure 40 may be formed on top of the LED chip 30, which is a second surface (top side) of the growth substrate 32 facing the opposite of the wiring substrate 10. The cavity structure 40 may comprise cylinder-type holes, polygonal shape cavities, or 2-dimensional grooves like circles or lines, and may be fabricated by wet etching, plasma dry etching, laser drilling, or any other methods. The holes, cavities and/or grooves (hereafter, cavities) in the cavity structure 40 may have various sizes, depths and lengths, and they may be formed in periodic arrangements on top of the LED chip 30. Dimensionally, each cavity may have sub-micron to tens of micron size in lateral on the top surface and microns to tens of micron size in depth. It is desirable that the end of each cavity facing the light emitting layer be hemispherical or have a gentle curvature to reduce the internal reflection. Various cavity types and arrangements are shown in FIG.1C. For example, if the cavity size is different, the periodic arrangement may also be different. Periodic arrangement of cavity structures with sizes and depths of a few micrometers or less on the light-emitting surface may increase the light extraction efficiency due to the so-called photonic crystal effect. For example, a relatively short wavelength emitting semiconductor QD material 51 can be embedded in the cavity design 1 having a tetragonal system with a lattice distance a, while another semiconductor QD material 52 which emits relatively longer wavelength than the semiconductor QD material 51 can be embedded in the cavity design 2 having a tetragonal system with a lattice distance b, where b is longer than a. That is, different cavity designs can be selected for different semiconductor QD materials emitting light of different wavelengths, which are matched to each other to increase the extraction efficiency based on the photonic crystal effect.

One or more semiconductor quantum dot (QD) materials 50 are embedded in the various cavities in the cavity structure 40 by various printing technologies like Inkjet or electro-hydrodynamic printings with very high accuracy. A portion of the primary light such as blue light emitted from the active layer of the semiconductor LED chip incident into the cavities can be converted to longer wavelengths by the semiconductor QD materials embedded in the cavity structure. The color of light converted from semiconductor QDs varies depending on their size and material. Therefore, an easy control in color conversion and its luminous intensity from the semiconductor QD material can be obtained by tuning both the cavity design and the semiconductor QD materials in size and type. Furthermore, a coherent embedment of a semiconductor QD material into the cavity structure having a coherent periodicity matched between the wavelength converted from the semiconductor QD material and the photonic crystal band of the cavity structure can enhance the light extraction efficiency.

A polymer epoxy resin or silicone resin protective layer 60 is disposed on the top of the LED chip, where the semiconductor QD material 50 is already embedded in the cavity structure, which can prevent the semiconductor QD material 50 from contacting external oxygen and water vapor.

One or more phosphor layers 70 may be provided to cover the entire LED chip 30 including the protective layer 60 to convert a portion of the primary light emitted and escaped from the LED chip 30. It is desirable that the conversion wavelength of the phosphor layer 60 on the outside of the LED chip 30 be shorter than the conversion wavelength of the semiconductor QD materials 50 inside to reduce the reabsorption of the converted lights by phosphors, but this limitation is not necessarily required. For a high CRI white LED lamp, a red phosphor material may be selected for a broad red spectrum. With another background color converted from the phosphor layer 70, now the colors from all semiconductor QD materials 50 can be manipulated to produce a continuous spectrum with high CRI more than 90, addressing the issue of spectral continuity, which is a discontinuous or spiky spectrum in RGB emitters and typical phosphor conversion LED lamps.

In one embodiment, the cavity structure 40 may be formed on the growth substrate 32, penetrating the growth substrate 32 to reach into the semiconductor epitaxial layer 31, as shown in FIG. 2A. For example, when a GaN growth substrate is used for LED chip growth, the cavity structure can extend to the semiconductor epitaxial layer to increase light extraction efficiency because the cavity fabrication on the GaN growth substrate is more stable and efficient than on sapphire by using a wet etching, plasma dry etching or laser drilling process.

In another embodiment, the cavity structure 40 may also be fabricated directly on the semiconductor epitaxial layer 31 where the growth substrate 32 has been removed, as shown in FIG. 2B. For example, the sapphire growth substrate may be removed after the semiconductor LED chip is grown for some reasons and other growth substrates such as Si or SiC must be removed for lighting applications. FIG. 2C shows a more specific structure of the LED packaging in this embodiment, where the cavity structure 40 is formed on the n-type GaN epitaxial layer 311 after a growth substrate has been removed from the LED chip 30. The LED chip 30 comprising an active layer 312 in between the n-GaN epitaxial layer 311 and p-GaN epitaxial layer 313 is connected electrically to the wiring substrate 10 through the metallic n-pad 22 and p-Pad 21, and a resin bonding layer referred here as the underfill resin 24 is used to stably bond the LED chip 30 with the wiring substrate 10.

In another embodiment, the protective layer 60 may contain alti-reflective nanoparticles such as TiO2 and may cover the side surfaces of the LED chip 30 that allows more extraction of the primary light from the LED chip 30, as shown in FIG. 3.

In some embodiments, the protective layer 60 may contain high thermal conductive nano-lines such as carbon nanowires/nanotubes or silver nanowires and may cover the side surfaces of the LED chip 30 that allows heat transfer from the top of the LED chip 30 toward the wiring substrate 10, as shown in FIGS. 4A-4B. It should be noted that in this embodiment, it is preferable that the protective layer 60 is connected to the wiring substrate 10 directly (Fig. 4B) or through the thermal pads 23 (Fig. 4A) for better heat dissipation. Although the flip-chip LED packaging structure has excellent heat dissipation advantages, under operating conditions requiring high brightness, if the heat reaching the growth substrate 32 is not effectively dissipated, it can seriously affect the QD materials 50 in the cavity structure 40. Therefore, a heat dissipation path can be formed through the protective layer 60 from the top of the LED chip 30 to the wiring substrate 10, which is attached to the metal base as a heat spreader or even to an external heat sink (not shown here).

FIG. 4C are a schematic cross-sectional view of a flip-chip on board packaging structure of the LED 1 according to an optional embodiment of the present invention that a heat dissipation layer 63 is introduced on top of the protective layer 60. Graphene is an allotrope of carbon consisting of a single layer of atoms arranged in a honeycomb nanostructure showing an exceptionally large thermal conductivity up to 5300 W/(m·K). In fact, a graphene sheet can be composed of several single-layer graphene. The thermal conductive interlayer can be formed by a polymer-2d material composite, in particular a graphene-PMMA (polymethyl methacrylate) or some other material that has similar properties related to a graphene-PMMA, which is a synthetic polymer commonly known as acrylic or acrylic glass. It's a transparent thermoplastic often used as a lightweight or shatter-resistant alternative to glass. Thermal conductivity of PMMA and silicone with Graphene for a single-layer graphene (SLG) supported was measured as 743 ± 167 W/(m K) at 296 K. Therefore, a graphene sheet on or inside the protective layer 60 can be an excellent heat dissipation layer 63 to protect the semiconductor QD materials from the heat coming from the junction of the LED chip 30. As mentioned above, it is preferable that the heat dissipation layer 63 on the protective layer 60 is connected to the wiring substrate 10 for better heat dissipation. The technical details of the heat dissipation layer can be further referred to the European Patent Application No. 24185942.0, which is incorporated herein by reference in its entirety.

While the invention has been described with reference to the specific embodiments thereof, it should be understood by those skilled in the art that various changes may be made and equivalents may be substituted without departing from the true spirit and scope of the disclosure as defined by the appended claims. In addition, many modifications may be made to adapt a particular situation, material, composition of matter, method, or process to the objective, spirit and scope of the disclosure. All such modifications are intended to be within the scope of the claims appended hereto. While the methods invented herein have been described with reference to particular operations performed in a particular order, it will be understood that these operations may be combined, sub-divided, or re-ordered to form an equivalent method without departing from the teachings of the invention. Accordingly, unless specifically indicated herein, the order and grouping of the operations are not limitations of the invention.

## Claims

1. A flip-chip packaging structure of a light-emitting device (1), LED, comprising:
a wiring substrate (10);
a flip-chip semiconductor LED chip (30) electrically connected to the wiring substrate (10);
a cavity structure (40) on top of the flip-chip semiconductor LED chip (30);
a color conversion semiconductor quantum dot material (50) embedded inside the cavity structure (40);
a protective layer (60) on top of the flip-chip semiconductor LED chip (30) and the cavity structure (40); and
a color conversion phosphor layer (60) entirely or partially encapsulating the LED chip (30).

2. The flip-chip packaging structure of the light-emitting device of claim 1, wherein the cavity structure (40) comprises one or more cavities such as any shapes of holes, pits, recesses, or lineal or 2-dimensional grooves.

3. The flip-chip packaging structure of the light-emitting device (1) of claim 1 or 2, wherein the cavity structure (50) comprises one or more two-dimensional cavity arrays.

4. The flip-chip packaging structure of the light-emitting device (1) according to one of the preceding claims , wherein the cavity structure (50) is formed on a growth substrate (32), and/or n-type semiconductor epitaxial layer (31) of the flip-chip semiconductor LED chip (30) .

5. The flip-chip packaging structure of the light-emitting device (1) according to one of the preceding claims, wherein the color conversion semiconductor quantum dot material (50) converts the emitting lights from the flip-chip semiconductor LED chip (30) to longer wavelengths.

6. The flip-chip packaging structure of the light-emitting device (1) according to one of the preceding claims, wherein the protective layer (60) comprises a polymer matrix material having a water vapor transmission rate of not more than 20 g/(m²·day) at a thickness of 1 mm.

7. The flip-chip packaging structure of the light-emitting device (1) according to one of the preceding claims, wherein the protective layer (60) comprises anti-reflective materials such as TiO2, which adjusts the refractive index value in the protective layer to be lied between the values of the flip-chip semiconductor LED chip (30) and the phosphor layer (70).

8. The flip-chip packaging structure of the light-emitting device (1) according to one of the preceding claims, wherein the protective layer (60) comprises any thermal conductive materials such as silver nanowires, carbon nanowires/nanotubes, ceramic particles or 2-dimensional graphene/graphene composite sheets.

9. The flip-chip packaging structure of the light-emitting device (1) according to one of the preceding claims, wherein the protective layer (60) encloses the flip-chip semiconductor LED chip (30) and is connected to the wiring substrate (10).

10. The flip-chip packaging structure of the light-emitting device (1) according to one of the preceding claims, wherein the protective layer (60) comprises any color conversion semiconductor quantum dot or phosphor materials.

11. The flip-chip packaging structure of the light-emitting device according to one of the preceding claims, wherein the color conversion phosphor layer converts the emitting lights from the flip-chip semiconductor LED chip to longer wavelengths.
